# EUROPEAN PATENT APPLICATION

(11) **EP 1 638 154 A1**
(43) Date of publication of application: **22.03.2006**
(21) Application number: 04090520.0
(22) Date of filing: 29.12.2004
(51) Int. Cl.: H01L 51/10, H01L 51/50

(54) **Organic light emitting display and method of fabricating the same**

(30) Priority: 21.09.2004 KR 2004075643
(71) Applicant: Samsung SDI Co., Ltd., Suwon-si, Gyeonggi-do (KR)
(72) Inventor: Kang, Tae-Wook, c/o Samsung SDI Co., Ltd., Suwon-shi Gyeonggi-do (KR); Kim, Mu-Hyun, c/o Samsung SDI Co., Ltd., Suwon-shi Gyeonggi-do (KR); Song, Myung-Won, c/o Samsung SDI Co., Ltd., Suwon-shi Gyeonggi-do (KR)
(74) Representative: Gulde, Klaus W.

(57) **Abstract**

An organic light emitting display and method of fabricating the same are provided. The OLED and method of fabricating the same is capable of forming an inorganic pixel defining layer having an opening for exposing at least a portion of the first electrode and making the inorganic pixel defining layer have a curved top surface without breakpoints. Since the top surface of the inorganic pixel defining layer has the curved cross-section without breakpoints, the first electrode and the organic layer pattern are closely adhered during a laser induced thermal imaging process to enable the transfer using a laser beam having low energy, thereby improving transfer efficiency, improving luminous efficiency of the OLED, and increasing lifetime of the OLED.

## Description

### CROSS-REFERENCE TO RELATED APPLICATION

This application claims priority to and the benefit of Korean Patent Application No. 2004-0075643, filed September 21, 2004, the disclosure of which is hereby incorporated herein by reference in its entirety.

### BACKGROUND OF THE INVENTION

### 1. Field of the Invention

The present invention relates to an organic light emitting display and method of fabricating the same and, more particularly, to an organic light emitting display including an inorganic pixel defining layer having a curved top surface without breakpoints and method of fabricating the same.

### 2. Description of the Related Art

Since an organic light emitting display (OLED) of flat panel displays is an emissive display in which an organic compound is electrically excited to emit light, it does not require a backlight unit unlike a liquid crystal display (LCD), thereby manufacturing the lightweight and thin OLED and simplifying the processes. In addition, since the OLED may be fabricated at a low temperature and has a fast response speed of 1 ms or less, low power consumption, a wide viewing angle owing to the emissive display, and high contrast, the OLED is attracting public attention as a next generation flat panel display.

In general, the OLED includes an organic emission layer between an anode and a cathode so that a hole supplied from the anode and an electron supplied from the cathode are combined in the organic emission layer to form an exciton as a hole-electron pair and the exciton is returned to the ground state to generate energy, thereby emitting light.

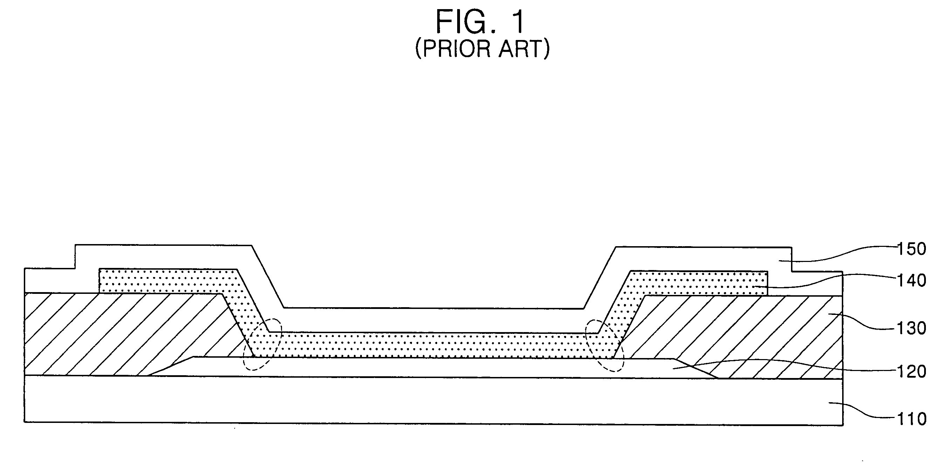

FIG. 1 is a cross-sectional view of a conventional OLED. Referring to FIG. 1, a patterned anode 120 is formed on a substrate 110 having a predetermined element.

An organic pixel defining layer 130 for defining a pixel region and made of an insulating material in order to insulate between organic emission layers is formed on the anode 120. Typically, the organic pixel defining layer 130 is made of one organic material selected from a group consisting of polyimid (PI), polyamide (PA), acryl resin, benzocyclobuthene (BCB), and phenol resin.

The organic pixel defining layer 130 may be deposited on the substrate using a spin coating method. The organic pixel defining layer 130 formed by the spin coating method has a thickness of 1 µm ~ 2 µm. The organic pixel defining layer 130 is patterned to form an opening, and an organic layer pattern 140 including an organic emission layer is formed on the organic pixel defining layer 130 in addition to the exposed anode.

A cathode 150 is formed on an entire surface of the organic layer pattern 140.

As described above, in the conventional OLED, the organic pixel defining layer 130 has been formed using an organic material. In this case, since the organic pixel defining layer 130 is formed to a large thickness of 1 µm ~ 2 µm, problems may occur that the organic layer pattern 140 formed by the following laser induced thermal imaging process is cut due to a large step of the anode and the organic pixel defining layer 130. Dotted lines designate portions where the organic layer pattern may be cut. In addition, since the organic pixel defining layer 130 is thick, it is difficult to make the anode and the organic layer on a donor substrate closely adhere to each other to thereby require a laser beam having high energy during the laser induced thermal imaging process. Therefore, there are problems of degrading transfer efficiency, lowering luminous efficiency of the OLED, and reducing lifetime of the OLED.

### SUMMARY OF THE INVENTION

The present invention, therefore, solves aforementioned problems associated with conventional devices by providing an OLED and method of fabricating the same capable of improving transfer efficiency, improving luminous efficiency of the OLED, increasing lifetime of the OLED, and preventing a organic layer pattern from being cut, by forming a pixel defining layer using an inorganic material to a small thickness and making the inorganic pixel defining layer have a curved top surface without breakpoints.

In an exemplary embodiment of the present invention, an organic light emitting display includes: a substrate; a first electrode formed on the substrate; an inorganic pixel defining layer formed on the first electrode and having an opening for exposing at least a portion of the first electrode; an organic layer pattern located on the first electrode and both ends of the inorganic pixel defining layer having the opening and having at least an emission layer; and a second electrode formed on the organic layer pattern, wherein the top surface of the inorganic pixel defining layer having the opening has a curved cross-section without breakpoints. The top surface of the inorganic pixel defining layer having the opening may have the curved cross-section without breakpoints at a portion in contact with the first electrode.

In another exemplary embodiment according to the present invention, a method of fabricating an OLED includes: providing a substrate; forming a first electrode on the substrate; forming an inorganic pixel defining layer on the substrate having the first electrode; patterning the inorganic pixel defining layer to form an opening for exposing at least a portion of the first electrode; patterning the inorganic pixel defining layer having the opening to make the top surface of the inorganic pixel defining layer have a curved cross-section without breakpoints; forming an organic layer pattern having at least an emission layer on the first electrode and both ends of the inorganic pixel defining layer having the opening; and forming a second electrode on the organic layer pattern. In patterning the inorganic pixel defining layer having the opening, the inorganic pixel defining layer having the opening may be patterned to make the top surface of the inorganic pixel defining layer have a curved cross-section without breakpoints at a portion in contact with the first electrode.

The opening of the inorganic pixel defining layer may be formed by a dry or wet etching method. Preferably, the inorganic pixel defining layer having the opening is formed by the dry etching method.

The inorganic pixel defining layer may be formed by a chemical vapor deposition (CVD) method or a physical vapor deposition (PVD) method. In addition, the PVD method may employ a sputtering method.

The inorganic pixel defining layer may be formed by a spin coating method.

The inorganic pixel defining layer may be formed to a thickness of 100 ~ 3000 Å, preferably, 100 ~ 1000 Å. In addition, the inorganic pixel defining layer may be made of one material selected from a group consisting of an amorphous silicon layer, a silicon oxide layer, a silicon nitride layer, and a silicon oxynitride layer. In the case of using the spin coating method, preferably, materials such as SOG (spin on glass) may be used.

The first electrode may be an anode, and the second electrode may be a cathode, on the contrary, the first electrode may be a cathode, and the second electrode may be an anode.

### BRIEF DESCRIPTION OF THE DRAWINGS

The above and other features of the present invention will be described in reference to certain exemplary embodiments thereof with reference to the attached drawings in which:
FIG. 1 is a cross-sectional view of a conventional OLED;
FIG. 2 is a cross-sectional view of an OLED in accordance with the present invention; and
FIGS. 3A to 3E are process cross-sectional views illustrating a method of fabricating an OLED in accordance with the present invention.

### DETAILED DESCRIPTION OF THE INVENTION

The present invention will now be described more fully hereinafter with reference to the accompanying drawings, in which preferred embodiments of the invention are shown. This invention may, however, be embodied in different forms and should not be construed as limited to the embodiments set forth herein. Like reference numerals designate like elements throughout the specification.

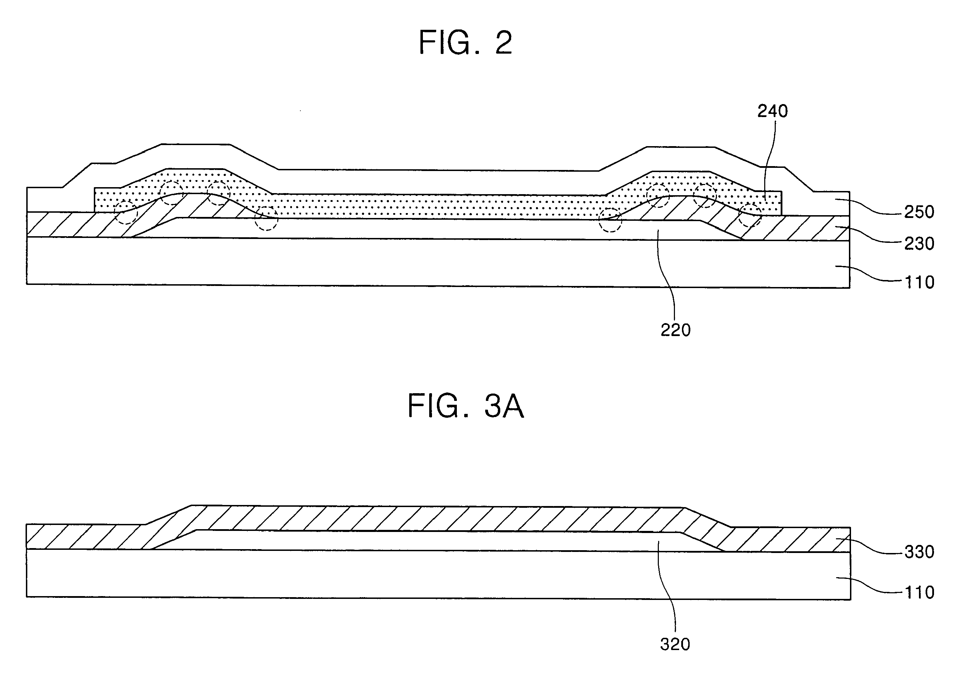

FIG. 2 is a cross-sectional view of an OLED in accordance with the present invention.

Referring to FIG. 2, a predetermined element is formed on a substrate 110, and a first electrode 220 is patterned and formed on the substrate 110. The substrate 110 may use a transparent insulating substrate such as glass, plastic and quartz.

When the first electrode 220 is an anode, the first electrode may be a transparent electrode made of ITO or IZO having a high work function, or a reflection electrode having, as its lower layer, a reflection layer made of metal having high reflection characteristics such as aluminum, an aluminum alloy or the like. When the first electrode is a cathode, the first electrode may be a thin transparent electrode or a thick reflection electrode made of one material selected from a group consisting of Mg, Ca, Al, Ag and an alloy thereof, which are conductive metals having low work functions.

An inorganic pixel defining layer 230 is formed on an entire surface of the substrate including the first electrode 220, and includes an opening for exposing at least a portion of the first electrode 220.

The inorganic pixel defining layer 230 may be formed by a deposition method or a spin coating method. The deposition method may use various methods, for example, a chemical vapor deposition (CVD) method, a physical vapor deposition (PVD) method or the like. In particular, the PVD method preferably employs a sputtering method. The inorganic pixel defining layer 230 may be formed to a small thickness of 100 ∼ 3000 Å using the deposition method. In order to effectively perform transfer in a laser induced thermal imaging process during the following organic layer pattern forming processes, preferably, the inorganic pixel defining layer 230 has a thickness of 3000 Å or less. When the inorganic pixel defining layer 230 has a thickness of more than 3000 Å, problems may occur that the organic layer pattern to be formed in the following process is cut or transfer efficiency is lowered. More preferably, the inorganic pixel defining layer 230 is formed to a thin thickness of 100 ~ 1000 Å.

An opening may be formed by patterning the inorganic pixel defining layer 230 using a dry or wet etching method.

The inorganic pixel defining layer 230 may be patterned using photoresist to pattern based on the shape of the photoresist. Therefore, the patterned inorganic pixel defining layer 230 has an angled top surface so that a donor substrate having an organic layer and the substrate come off each other to lower transfer efficiency during the following laser induced thermal imaging (LITI) process, thereby requiring a laser beam having high energy. In addition, the organic layer pattern transferred to angled parts is readily fissured to cause cracks in a second electrode formed on the organic layer pattern. As a result, moisture or oxygen may be penetrated into the organic layer pattern through the cracks to cause the organic layer pattern to be deteriorated.

Therefore, the inorganic pixel defining layer is patterned such that the top surface of the inorganic pixel defining layer having the opening has a curved cross-section without breakpoints. Dotted lines designate portions having a curved shape without breakpoints after patterning. The inorganic pixel defining layer having the opening may be patterned by a dry etching process.

In addition, the top surface of the inorganic pixel defining layer having the opening may be patterned to have a curved cross-section without breakpoints at the portion in contact with the first electrode. A method of forming the curved cross-section without breakpoints may use a method of patterning the inorganic pixel defining layer using the dry or wet etching method and then dry etching the entire surface to pattern the angled portion into a curved portion without breakpoints.

The inorganic pixel defining layer 230 may be made of one inorganic material selected from a group consisting of amorphous silicon, a silicon oxide layer, a silicon nitride layer, and a silicon oxynitride layer.

An organic layer pattern 240 including at least an emission layer is formed on the first electrode 220 and both ends of the inorganic pixel defining layer having the opening. While the organic layer pattern 240 is transferred onto the first electrode 220 and the inorganic pixel defining layer 230 by irradiating a laser beam, since the inorganic pixel defining layer has a small thickness of 100 ∼ 1000 Å and a curved top surface without breakpoints, the first electrode and the donor substrate having the organic layer are more closely adhered during the laser induced thermal imaging process, thereby preventing the organic layer pattern from being cut. In addition, since the transfer may be performed using a laser beam having low energy, the transfer efficiency is also improved. Detailed description will be explained with reference to FIGS. 3A to 3E.

The organic layer pattern 240 may include at least one layer selected from a hole injection layer, a hole transport layer, a hole blocking layer, an electron transport layer, and an electron injection layer in addition to the emission layer.

A second electrode 250 is formed on the organic layer pattern 240. When the first electrode 220 is an anode, i.e., a transparent electrode or a reflection electrode having at least two layers including transparent layer and reflection layer on the transparent layer, the second electrode 250 may be formed of a reflection electrode, i.e., a cathode made of one selected from a group consisting of Mg, Ca, Al, Ag and an alloy thereof which are conductive metals having low work functions, and when the first electrode 220 is a cathode, the second electrode 250 may be formed of a transparent electrode, i.e., an anode made of ITO or IZO.

FIGS. 3A to 3E are process cross-sectional views illustrating a method of fabricating an OLED in accordance with the present invention.

Referring to 3A, a substrate 110 is provided. The substrate 110 may use a transparent insulating substrate such as glass, plastic, and quartz.

Next, a first electrode 320 is formed on the substrate 110. When the first electrode 320 is an anode, the first electrode 320 may be a reflection electrode including a reflection layer made of metal having a high reflexibility. When the first electrode 320 is a cathode, the first electrode may be formed of a thin transparent electrode or a thick reflection electrode made of one material selected from a group consisting of Mg, Ca, Al, Ag and an alloy thereof which are conductive materials having low work functions.

The first electrode 320 may be deposited by a sputtering method or an ion plating method. More preferably, the first electrode 320 may be deposited by a sputtering method, and then may be formed by selectively patterning using a photoresist (PR) as a mask through a wet etching method, wherein the PR is patterned in a photolithography process.

Next, an inorganic pixel defining layer 330 is formed on an entire surface of the substrate including the first electrode 320. The inorganic pixel defining layer 330 functions to define a unit pixel region.

While the conventional art uses an organic material as a pixel defining layer, the present invention uses an inorganic material to form the inorganic pixel defining layer 330. The inorganic material for forming the inorganic pixel defining layer 330 may use one selected from amorphous silicon, a silicon oxide layer, a silicon nitride layer, and a silicon oxynitride layer.

The inorganic pixel defining layer 330 is formed by a deposition method or a spin coating method. The deposition method for forming a thin layer generally uses a CVD or PVD method.

The CVD method is a method of forming a thin layer made of a desired material through a chemical reaction, which may be used to form the inorganic pixel defining layer. In the typical CVD process, a room temperature reaction gas is introduced into a reaction chamber. The reaction gas is heated until it arrives to a deposition surface, and heat is continuously supplied to the reaction gas by convection current or heating of the deposition surface. According to various process conditions, the reaction gas may cause a regular reaction in vapor before it arrives to the deposition surface. Since a gas flow is heated, speed is lowered due to viscosity, and gas composition is changed adjacent to the deposition surface, boundary layers of heat, momentum, and chemical composition are formed. The introduced gas or reaction intermediate (generated due to vapor thermal decomposition) causes an irregular reaction at the deposition surface, thereby forming a thin layer. Next, vapor byproducts are discharged from the reaction chamber. The inorganic pixel defining layer 330 may be formed by the CVD method. The CVD method may be classified into various methods, i.e., atmospheric pressure CVD (APCVD) and low pressure CVD (LPCVD) depending on pressure in the reaction chamber, and the APCVD may be classified into low temperature CVD (LTCVD) and high temperature CVD (HTCVD) depending on performed temperature. And otherwise, plasma CVD (PECVD), photo CVD (PHCVD) and so on may be used.

The PVD method is a method of applying energy to a substrate or a gob made of a thin material to physically separate a corresponding material having kinetic energy and then depositing the separated material on another substrate to form a thin layer, which may be classified into a sputtering method and a vacuum deposition method.

The sputtering method is a method of colliding high-energy particles to a substrate made of the same material as a desired thin layer to separate an atom and a molecule, thereby forming a thin layer. On the other hand, the vacuum deposition method is a method of heating a material, which is to be deposited, in a vacuum vessel to deposit the material on a substrate by the increased vapor pressure. The inorganic pixel defining layer 330 may be formed by the PVD method.

The spin coating method is a method of rotating a member being coated, and dropping a coating material on a center portion of the rotated member to make the coating material spread out to a small thickness on an entire surface, thereby completing the coating operation. The inorganic pixel defining layer 330 may be formed of the organic material as the coating material using the spin coating method.

As described above, the present invention is characterized in that the inorganic pixel defining layer 330 is formed by the deposition method or the spin coating method. The inorganic pixel defining layer 330 formed by the deposition method may be formed to a thickness of 100 ~ 3000 Å. In addition, preferably, the inorganic pixel defining layer 330 is formed to a small thickness of 100 ~ 1000 Å, and may also be formed to a thickness of 100 Å.

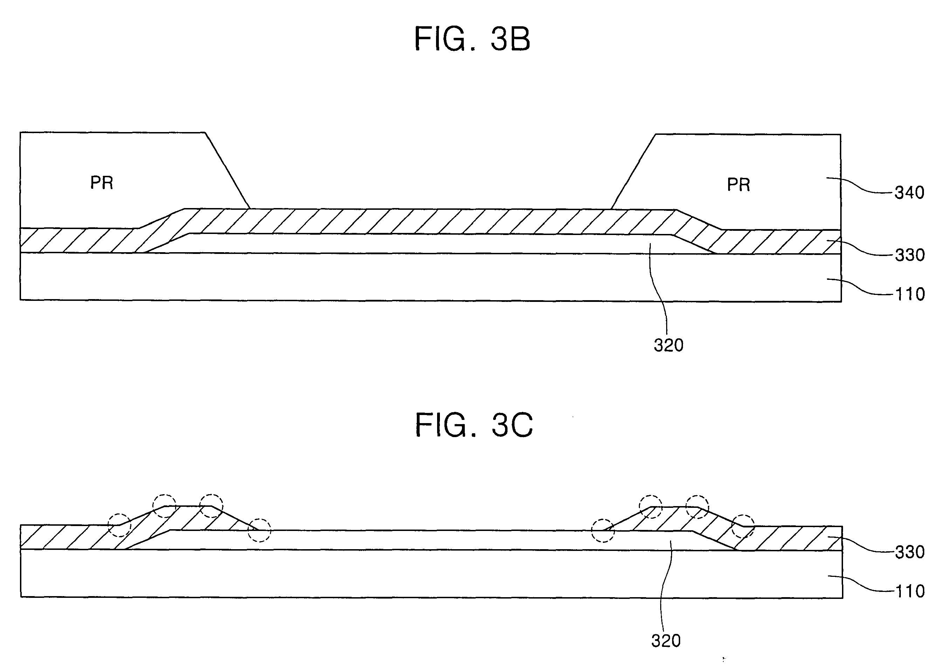

Referring to FIGS. 3B and 3C, the inorganic pixel defining layer 330 is patterned to form an opening for exposing at least a portion of the first electrode 320. The inorganic pixel defining layer 330 may be patterned by a dry or wet etching method.

The dry etching method is an etching method simultaneously using a physical action and a chemical action, i.e., a physical action by ion impact and a chemical action of reaction materials generated in plasma or a chemical action by ions, electrons and photons.

The inorganic pixel defining layer 330 is selectively removed by the etching process using a photoresist pattern 340 formed in a photolithography process to be transferred and formed as a pattern designed in a reticle. Preferably, the dry etching method uses a plasma etching method of plasma discharging in constant pressure of chamber to decompose a reaction gas into ions, radicals, and electrons, and of causing the radicals generated at this time to generate a chemical reaction and the resulting etching action.

The wet etching method is a method of removing the inorganic pixel defining layer 330 corresponding to the photoresist pattern 340 using a chemical solution, which may use a dipping method, a spray method, and a composite method.

As a result of etching and patterning the inorganic pixel defining layer 330, it is appreciated that the top surface of the inorganic pixel defining layer 330 has an angled cross-section. Dotted lines designate portions where the top surface of the inorganic pixel defining layer 330 has an angled cross-section.

As shown in FIG. 2, when the inorganic pixel defining layer 330 has the angled top surface, the transfer efficiency is lowered during the transfer process using the LITI method. In addition, the organic layer pattern is readily fissured to cause cracks in a second electrode formed on the organic layer pattern, therefore, moisture or oxygen is penetrated into the organic layer pattern through the cracks to cause the organic layer pattern to be deteriorated.

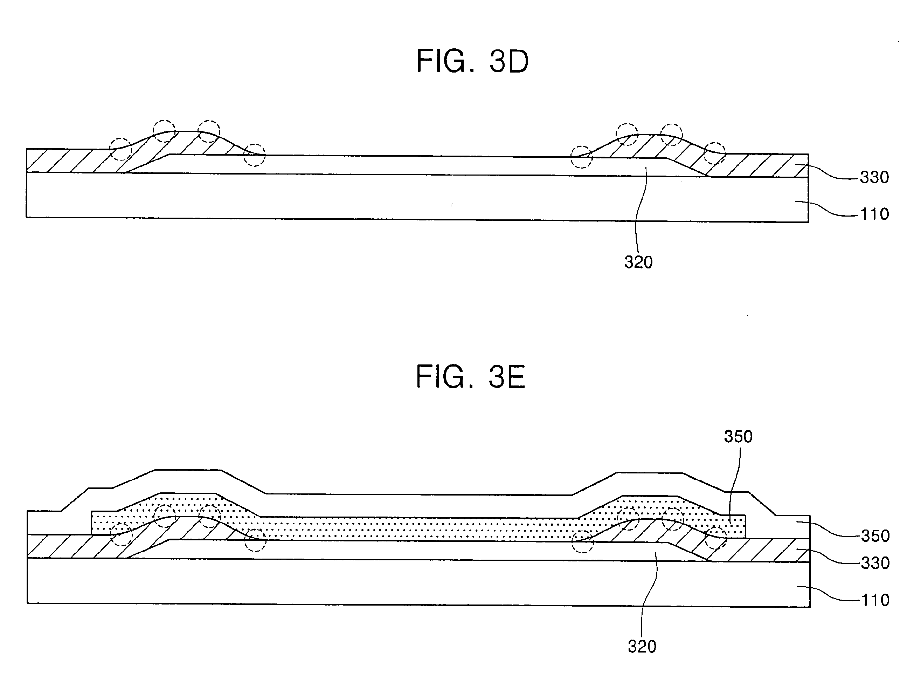

Referring to FIG. 3D, the inorganic pixel defining layer 330 having the opening is patterned to have a curved top surface. At this time, the inorganic pixel defining layer 330 is preferably patterned by the dry etching method. In addition, the top surface of the inorganic pixel defining layer 330 may be patterned to have a curved cross-section without breakpoints at the portion in contact with at least the first electrode.

Referring to FIG. 3E, an organic layer pattern 340 including at least an emission layer is formed on the first electrode 320 and both ends of the inorganic pixel defining layer 330 having the opening. The organic layer pattern 340 may be formed by various methods such as inkjet printing, spin coating, deposition and so on, preferably the LITI (laser induced thermal imaging) method. When the organic layer pattern 340 is formed by the LITI method, a donor substrate (not shown) having an organic layer is laminated on an entire surface of the substrate, and then the laser beam is irradiated on a predetermined region of the donor substrate to form the organic layer pattern 340 on the first electrode 320 and both ends of the inorganic pixel defining layer 330 having the opening.

At this time, as described above, since the inorganic pixel defining layer 330 is formed to a small thickness of 100 ~ 3000 Å, preferably, 100 ~ 1000 Å, a step between the first electrode 320 and the inorganic pixel defining layer 330 is formed to a small height, and the top surface of the inorganic pixel defining layer 330 has the curved cross-section without breakpoints, thereby improving transfer efficiency during the process of forming the organic layer pattern 340. That is, since the transfer may be performed using the laser beam having low energy, luminous efficiency and lifetime of the OLED may be increased. In addition, it is possible to prevent the organic layer pattern from being cut.

The organic layer pattern 340 includes at least an emission layer, and may further include at least one layer selected from a hole injection layer, a hole transport layer, a hole blocking layer, an electron transport layer, and an electron injection layer in addition to the emission layer.

Continuously, a second electrode 350 is formed on an entire surface of the organic layer pattern 340. The second electrode 350 may be formed by a vacuum deposition method. When the first electrode 320 is a transparent electrode as an anode or a reflection electrode having at least two layers including transparent layer and reflection layer on the transparent layer, the second electrode is a reflection electrode, i.e., a cathode formed on one material selected from a group consisting of Mg, Ca, Al, Ag and an alloy thereof which are conductive metals having low work functions, and when the first electrode 320 is a cathode, the second electrode 350 is a transparent electrode, i.e., an anode formed of ITO or IZO.

As can be seen from the foregoing, an OLED and method of fabricating the same in accordance with the present invention is capable of forming an inorganic material as a pixel defining layer to a small thickness using a deposition method and then patterning the top surface of the inorganic pixel defining layer to have a curved cross-section without breakpoints. As a result, it is possible to improve transfer efficiency, improve luminous efficiency of the OLED, and increase lifetime of the OLED by making the first electrode and the organic layer on the donor substrate closely adhere to each other during a laser induced thermal imaging process to thereby enable the transfer using a laser beam having low energy. In addition, there is an advantage of preventing the organic layer pattern formed by the LITI process from being cut due to the step between the first electrode and the inorganic pixel defining layer.

Although the present invention has been described with reference to certain exemplary embodiments thereof, it will be understood by those skilled in the art that a variety of modifications and variations may be made to the present invention without departing from the spirit or scope of the present invention defined in the appended claims, and their equivalents.

## Claims

1. An organic light emitting display comprising:
a substrate;
a first electrode formed on the substrate;
an inorganic pixel defining layer formed on the first electrode and having an opening for exposing at least a portion of the first electrode;
an organic layer pattern located on the first electrode and both ends of the inorganic pixel defining layer having the opening and having at least an emission layer; and
a second electrode formed on the organic layer pattern,
wherein the top surface of the inorganic pixel defining layer has a curved cross-section without breakpoints.

2. The organic light emitting display according to claim 1, wherein the top surface of the inorganic pixel defining layer has a curved cross-section without breakpoints at a portion in contact with the first electrode.

3. The organic light emitting display according to claim 1, wherein the inorganic pixel defining layer is formed by any one of a chemical vapor deposition (CVD) method and a physical vapor deposition (PVD) method.

4. The organic light emitting display according to claim 3, wherein the inorganic pixel defining layer is formed by a sputtering method.

5. The organic light emitting display according to claim 1, wherein the inorganic pixel defining layer is formed by a spin coating method.

6. The organic light emitting display according to claim 1, wherein the inorganic pixel defining layer is formed to a thickness of 100 ~ 3000 Å.

7. The organic light emitting display according to claim 6, wherein the inorganic pixel defining layer is formed to a thickness of 100 ~ 1000 Å.

8. The organic light emitting display according to claim 1, wherein the inorganic pixel defining layer is made of one material selected from a group consisting of an amorphous silicon layer, a silicon oxide layer, a silicon nitride layer, and a silicon oxynitride layer.

9. The organic light emitting display according to claim 1, wherein the first electrode is an anode, and the second electrode is a cathode.

10. The organic light emitting display according to claim 1, wherein the first electrode is a cathode, and the second electrode is an anode.

11. A method of fabricating an organic light emitting display, comprising:
providing a substrate;
forming a first electrode on the substrate;
forming an inorganic pixel defining layer on the substrate having the first electrode;
patterning the inorganic pixel defining layer to form an opening for exposing at least a portion of the first electrode;
patterning the inorganic pixel defining layer having the opening to make the top surface of the inorganic pixel defining layer have a curved cross-section without breakpoints;
forming an organic layer pattern having at least an emission layer on the first electrode and both ends of the inorganic pixel defining layer having the opening; and
forming a second electrode on the organic layer pattern.

12. The method according to claim 11, wherein in patterning the inorganic pixel defining layer having the opening, the inorganic pixel defining layer is patterned to make the top surface of the inorganic pixel defining layer have a curved cross-section without breakpoints at a portion in contact with the first electrode.

13. The method according to claim 11, wherein the inorganic pixel defining layer having the opening is patterned by a dry etching method.

14. The method according to claim 11, wherein the inorganic pixel defining layer is formed by any one of a chemical vapor deposition (CVD) method and a physical vapor deposition (PVD) method.

15. The method according to claim 14, wherein the inorganic pixel defining layer is formed by a sputtering method.

16. The method according to claim 11, wherein the inorganic pixel defining layer is formed by a spin coating method.

17. The method according to claim 11, wherein the inorganic pixel defining layer is formed to a thickness of 100 ~ 3000 Å.

18. The method according to claim 17, wherein the inorganic pixel defining layer is formed to a thickness of 100 ~ 1000 Å.

19. The method according to claim 11, wherein the inorganic pixel defining layer is made of one material selected from a group consisting of an amorphous silicon layer, a silicon oxide layer, a silicon nitride layer, and a silicon oxynitride layer.

20. The method according to claim 11, wherein the first electrode is an anode, and the second electrode is a cathode.

21. The method according to claim 11, wherein the first electrode is a cathode, and the second electrode is an anode.

22. The method according to claim 11, wherein the opening of the inorganic pixel defining layer is formed by a dry etching method.

23. The method according to claim 11, wherein the opening of the inorganic pixel defining layer is formed by a wet etching method.
